# EUROPEAN PATENT APPLICATION

(11) **EP 4 730 307 A1**
(43) Date of publication of application: **22.04.2026**
(21) Application number: 24845793.9
(22) Date of filing: 07.06.2024
(51) Int. Cl.: G09G 3/00, G09G 3/3208, H10K 59/131, H10K 59/122, H10K 59/88, H10K 77/10, G06F 1/16, H04M 1/02

(54) **ELECTRONIC DEVICE COMPRISING DISPLAY PANEL HAVING CONDUCTIVE MATERIAL FOR SENSING**

(30) Priority: 27.07.2023 KR 20230098530; 24.08.2023 KR 20230111282
(71) Applicant: Samsung Electronics Co., Ltd., Suwon-si, Gyeonggi-do 16677 (KR)
(72) Inventor: JEON, Namhyeon, Suwon-si Gyeonggi-do 16677 (KR); EOM, Gyudong, Suwon-si Gyeonggi-do 16677 (KR); LEE, Dongseop, Suwon-si Gyeonggi-do 16677 (KR); LEE, Heesoo, Suwon-si Gyeonggi-do 16677 (KR)
(74) Representative: Gulde & Partner
(86) International application number: PCT/KR2024/007801
(87) International publication number: WO 2025/023489

(57) **Abstract**

An electronic device is provided. The electronic device may comprise: sub-pixels, each including a light-emitting diode; a pixel definition layer (PDL) for defining a layout of the sub-pixels; a display panel which includes a conductive material formed in a portion of the PDL and which is at least partially deformed on the basis of a user input; a display driving circuit for controlling the light-emitting diodes in order to display an image on the display panel; and a processor.

## Description

### [Technical Field]

The following descriptions relate to an electronic device comprising a display panel having conductive materials for sensing.

### [Background Art]

An electronic device may comprise a display for providing visual information and/or visual data. The display may be deformable. For example, since the display is deformable, the display may provide a relatively wide screen or may provide a relatively compact structure.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

An electronic device is provided. The electronic device may comprise a display panel, which includes sub pixels respectively including light emitting diodes, a pixel definition layer (PDL) defining a layout of the sub pixels, and conductive materials formed in a portion of the PDL, configured to be at least partially deformed based on a user input. The electronic device may comprise display driver circuitry configured to control the light emitting diodes to display an image on the display panel. The electronic device may comprise a processor. The display driver circuitry may be configured to transmit, to the processor, data regarding a state of at least a portion of the conductive materials that is configured to be electrically connected to the display driver circuitry. The processor may be configured to execute a function corresponding to at least partial deformation of the display panel by the user input, based on the data received from the display driver circuitry.

An electronic device is provided. The electronic device may comprise a display panel including a first part including sub pixels and a first pixel definition layer (PDL) defining a layout of the sub pixels, and a second part including a second PDL defining dummy sub pixels and a layout of the dummy sub pixels and conductive materials formed in a portion of the second PDL. The display panel may be configured to be at least partially deformed based on a user input. The electronic device may comprise display driver circuitry. The electronic device may comprise a processor. The display driver circuitry may be configured to transmit, to the processor, data regarding a state of the conductive materials configured to be electrically connected to the display driver circuitry. The processor may be configured to execute a function corresponding to at least partial deformation of the display panel by the user input, based on the data received from the display driver circuitry.

### [Description of the Drawings]

FIGS. 1A to 1C illustrate examples of an electronic device having a display panel.
FIG. 1D is a simplified block diagram of an exemplary electronic device.
FIG. 2 illustrates an example of a display panel including conductive materials in a pixel definition layer (PDL) within an active area.
FIG. 3 illustrates an example of a display panel including conductive materials in a PDL outside an active area.
FIG. 4 is a cross-sectional view illustrating an example in which a display panel is cut along A-A' of FIG. 2 or A-A' of FIG. 3.
FIG. 5A illustrates an example of a connection relationship between display driver circuitry and a display panel.
FIG. 5B is a cross-sectional view illustrating an example in which a display panel is cut along A-B-C of FIG. 5A.
FIG. 6A illustrates an example of a foldable electronic device having a display panel including conductive materials in a PDL.
FIG. 6B illustrates components of display driver circuitry in a foldable electronic device for obtaining data regarding a state of at least a portion of conductive materials.
FIG. 7A illustrates an example of a rollable (or slidable) electronic device having a display panel including conductive materials in a PDL.
FIG. 7B illustrates components of display driver circuitry in a rollable electronic device for obtaining data regarding a state of at least a portion of conductive materials.
FIG. 7C illustrates an exemplary method of controlling switches of FIG. 7B.
FIG. 7D illustrates an example of data regarding a state of at least a portion of conductive materials.
FIG. 7E illustrates an example of a function executed based on data regarding a state of at least a portion of conductive materials.
FIG. 8 illustrates an example of conductive materials included in a stretchable display panel.
FIG. 9 is a block diagram of an electronic device in a network environment according to various embodiments.
FIG. 10 is a block diagram of a display module according to various embodiments.

### [Mode for Invention]

An electronic device may be a portable device such as a smartphone, tablet, or laptop. The electronic device may include a display panel for visually providing information and/or data. For example, as the display panel becomes wider, visibility of information may be improved, but portability of the electronic device may be decreased. For example, the display panel may be deformable to solve a trade-off between visibility and portability. As a non-limiting example, the display panel may be folded at least once. As a non-limiting example, the display panel may be at least partially rollable. As a non-limiting example, the display panel may be stretchable. The display panel may sometimes be referred to as a flexible display panel.

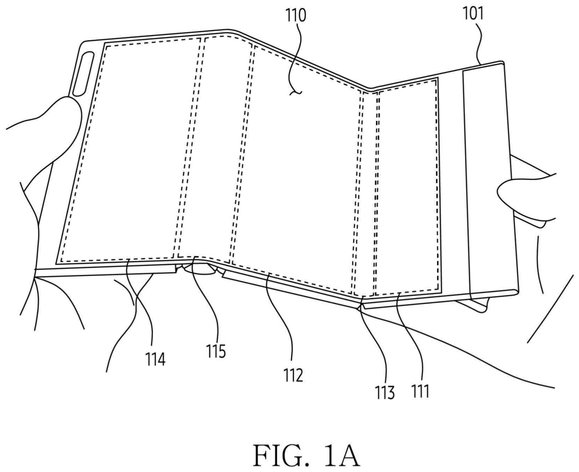

For example, the display panel may be included in electronic devices having various form factors. The electronic devices are exemplified in descriptions of FIGS. 1A to 1C.

FIGS. 1A to 1C illustrate examples of an electronic device having a display panel.

Referring to FIG. 1A, an electronic device may be a foldable electronic device 101 having a display panel 110. For the foldable electronic device 101, the display panel 110 may be foldable. For example, the display panel 110 may be folded at least once.

For example, in a case that the display panel 110 is foldable once, the display panel 110 may include a first planar part 111, a second planar part 112 having a front surface facing a front surface of the first planar part 111 in a folded state of the foldable electronic device 101, and a folding part 113 located between the first planar part 111 and the second planar part 112 to be bent between an unfolded state of the foldable electronic device 101 and the folded state.

For example, in a case that the display panel 110 is foldable twice, the display panel 110 may further include a third planar part 114 having a front surface facing a front surface of the first planar part 111 or facing a rear surface of the second planar part 112 in the folded state, and a folding part 115 located between the first planar part 111 and the third planar part 114 to be bent between the unfolded state and the folded state. However, it is not limited thereto. For example, the display panel 110 foldable twice may include, unlike illustrated in FIG. 1A, a third planar part 114 having a front surface facing a front surface of the second planar part 112 or facing a rear surface of the first planar part 111 in the folded state, and a folding part 115 located between the first planar part 111 and the third planar part 114 to be bent between the unfolded state and the folded state.

For example, the display panel 110 may be configured to be folded based on a user input. For example, the user input may be caused by a force applied to the foldable electronic device 101 to fold the display panel 110. The force may be caused from outside the foldable electronic device 101 or may be caused from inside the foldable electronic device 101. For example, the user input may be received by the foldable electronic device 101 to change a size of an area of the display panel 110 used for displaying information. For example, the user input may be received by the foldable electronic device 101 for executing a function capable of being supported through the foldable electronic device 101. For example, the user input may include an input intended by a user for the execution of the function. However, it is not limited thereto. For example, the user input may further include an input that is caused by the user but is not intended by the user.

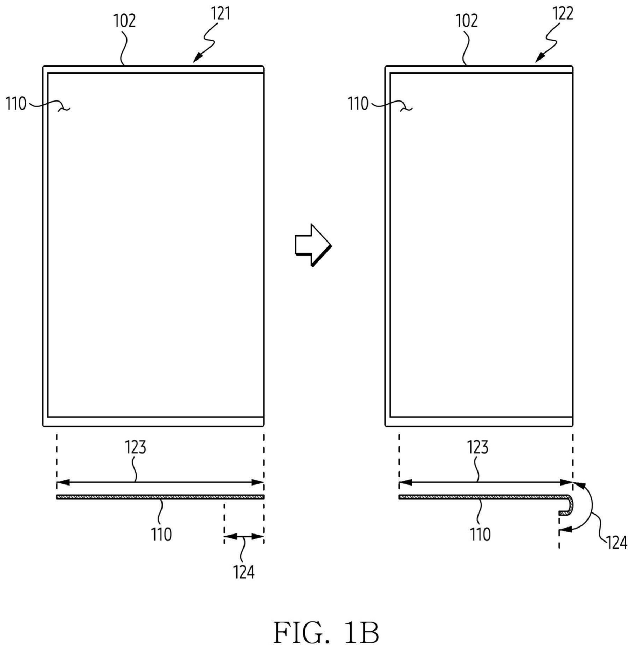

Referring to FIG. 1B, an electronic device may be a rollable electronic device 102 (or a slidable electronic device 102) having a display panel 110. For the rollable electronic device 102, the display panel 110 may be at least partially rollable. For example, at least a portion of the display panel 110 may be rolled.

For example, the display panel 110 may be at least partially rolled into a housing of the rollable electronic device 102 to change a size of an area 123 visible from a front surface of the rollable electronic device 102.

For example, in a case that the display panel 110 is partially rolled, the display panel 110 may include a part 124 capable of being rolled into the housing. For example, a front surface of the part 124 may be located outside the housing (e.g., external) for a first state 121 and may be located inside the housing (e.g., internal) for a second state 122. For example, since the front surface of the part 124 is located outside the housing for the first state 121 and located inside the housing for the second state 122, a size of the area 123 in the first state 121 may be larger than a size of the area 123 in the second state 122.

For example, the display panel 110 may be configured to be rolled based on a user input. For example, the user input may be caused by a force applied to the rollable electronic device 102 to at least partially roll the display panel 110. The force may be caused from outside the rollable electronic device 102 or may be caused from inside the foldable electronic device 102. For example, the user input may be received by the rollable electronic device 102 to change a size of an area of the display panel 110 used for displaying information. For example, the user input may be received by the rollable electronic device 102 for executing a function capable of being supported through the rollable electronic device 102. For example, the user input may include an input intended by a user for the execution of the function. However, it is not limited thereto. For example, the user input may further include an input not intended by the user.

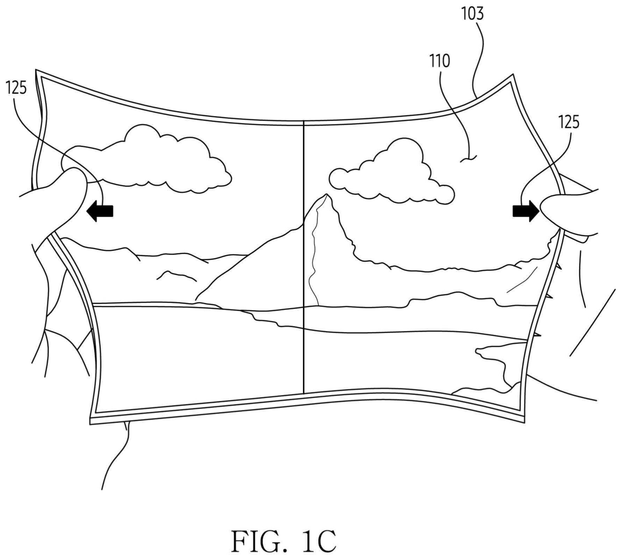

Referring to FIG. 1C, an electronic device may be a stretchable electronic device 103 having a display panel 110. For the stretchable electronic device 103, the display panel 110 may be at least partially stretchable.

For example, the display panel 110 may be at least partially stretched, as indicated by an arrow 125, to change a size of an area visible from a front surface of the stretchable electronic device 103. As a non-limiting example, the display panel 110 may be freely (or randomly) deformed compared to the display panel 110 exemplified in descriptions of FIGS. 1A and 1B.

For example, the display panel 110 may be configured to be stretched based on a user input. For example, the user input may be caused by a force applied to the stretchable electronic device 103 to at least partially stretch the display panel 110. The force may be caused from outside the stretchable electronic device 103 or may be caused from inside the stretchable electronic device 103. For example, the user input may be received by the stretchable electronic device 103 to change a size of an area of the display panel 110 used for displaying information. For example, the user input may be received by the stretchable electronic device 103 for executing a function capable of being supported through the stretchable electronic device 103. For example, the user input may include an input intended by a user for the execution of the function. However, it is not limited thereto. For example, the user input may further include an input not intended by the user.

The display panel 110 exemplified in descriptions of FIGS. 1A to 1C may be configured to be at least partially deformed based on a user input. For example, the user input may cause a change in a size and/or a shape of an area of the display panel 110 visible from a front surface of an electronic device (e.g., the foldable electronic device 101, the rollable electronic device 102, or the stretchable electronic device 103). As a non-limiting example, the user input may cause execution of a function. As a non-limiting example, since the function may be executed differently according to the change in the size and/or the shape, a means or a configuration for sensing a state of the display panel 110 according to the user input may be included in the electronic device (or the display panel 110). For example, the display panel 110 may include conductive materials to sense, detect, or identify the state of the display panel 110 according to the user input. For example, the conductive materials may be embedded in the display panel 110. The conductive materials may sometimes be referred to as a sensor, a sensing element, sensing circuitry, a strain sensor, or a strain gauge sensor.

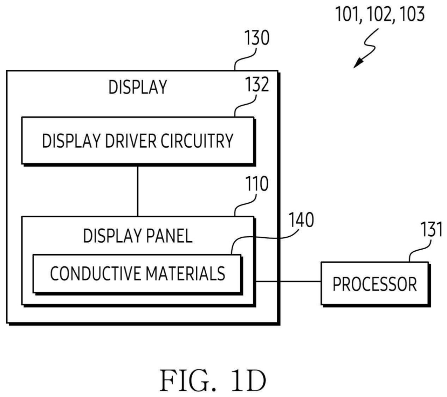

For example, in response to the user input, the electronic device may obtain data using the conductive materials and may execute the function based on the data. The electronic device may include components for obtaining the data and executing the function based on the data. The components are exemplified in descriptions of FIG. 1D.

FIG. 1D is a simplified block diagram of an exemplary electronic device.

Referring to FIG. 1D, an electronic device may be one of electronic devices (e.g., the foldable electronic device 101, the rollable electronic device 102, or the stretchable electronic device 103) having various form factors. For example, the electronic device may be one of various types of mobile devices such as a laptop, a smartphone, a cellular phone, a wearable device, a cellular phone, and other similar computing devices. Components illustrated in FIG. 1D, their relationships, and their functions are merely exemplary and do not limit implementations described or claimed in this document. The electronic device may sometimes be referred to as a user device, a multifunction device, or a portable (or handheld) device.

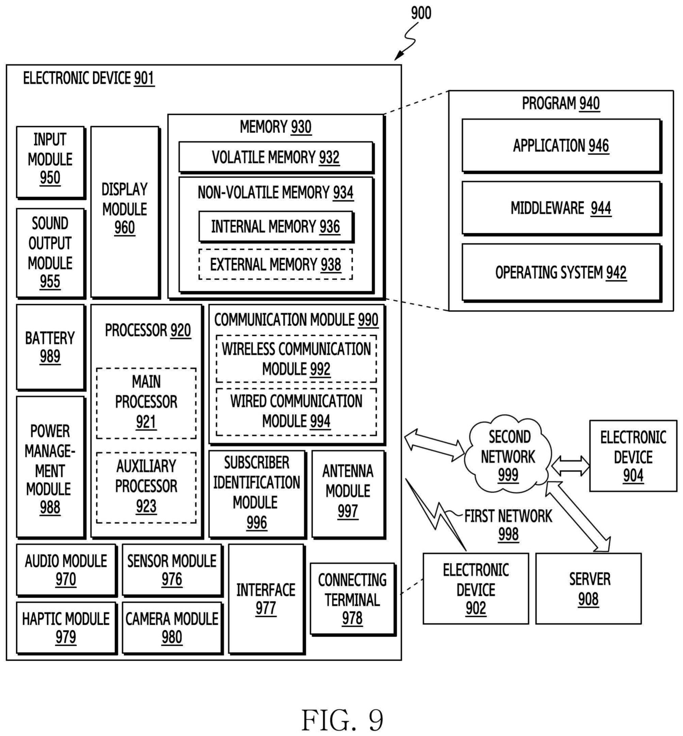

The electronic device may include at least a portion of the electronic device 901 of FIG. 9 or may correspond to at least a portion of the electronic device 901 of FIG. 9.

The electronic device may include a display 130 and a processor 131.

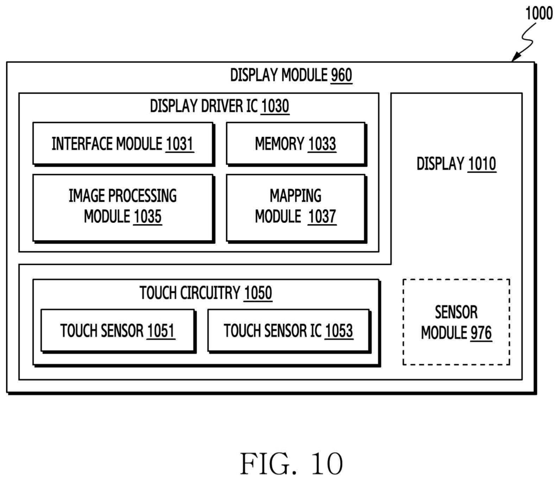

The display 130 may include at least a portion of the display module 960 of FIGS. 9 and 10 or may correspond to at least a portion of the display module 960 of FIGS. 9 and 10. The display 130 may include a display panel 110 and display driver circuitry 132.

The display panel 110 may include at least a portion of the display 1010 of FIG. 10 or may correspond to at least a portion of the display 1010 of FIG. 10.

The display panel 110 may be used to display an image, a screen, information, and/or data.

The display panel 110 may be configured to be at least partially deformed based on the user input. The display panel 110 may include conductive materials 140. As described above, the conductive materials 140 may be included in the display panel 110 to sense, detect, identify, discover, recognize, examine, verify, or check at least partial deformation of the display panel 110.

The display driver circuitry 132 may include at least a portion of the DDI 1030 of FIG. 10 or may correspond to at least a portion of the DDI 1030 of FIG. 10.

The display driver circuitry 132 may be used to display an image, a screen, information, and/or data on the display panel 110. For example, the display driver circuitry 132 may receive an image from the processor 131. For example, the display driver circuitry 132 may display the received image on the display panel 110.

The display driver circuitry 132 may obtain data regarding a state of at least a portion of the conductive materials 140 to sense, detect, identify, discover, recognize, examine, verify, or check at least partial deformation of the display panel 110. The display driver circuitry 132 may transmit the data to the processor 131.

The processor 131 may include at least a portion of the processor 920 of FIG. 9 or may correspond to at least a portion of the processor 920 of FIG. 9.

The processor 131 may be used to sense, detect, identify, discover, recognize, examine, verify, or check at least partial deformation of the display panel 110. The processor 131 may be used to execute a function corresponding to at least partial deformation of the display panel 110. For example, the processor 131 may receive the data from the display driver circuitry 132. For example, the processor 131 may execute a function corresponding to at least partial deformation of the display panel 110 by the user input, based on the data.

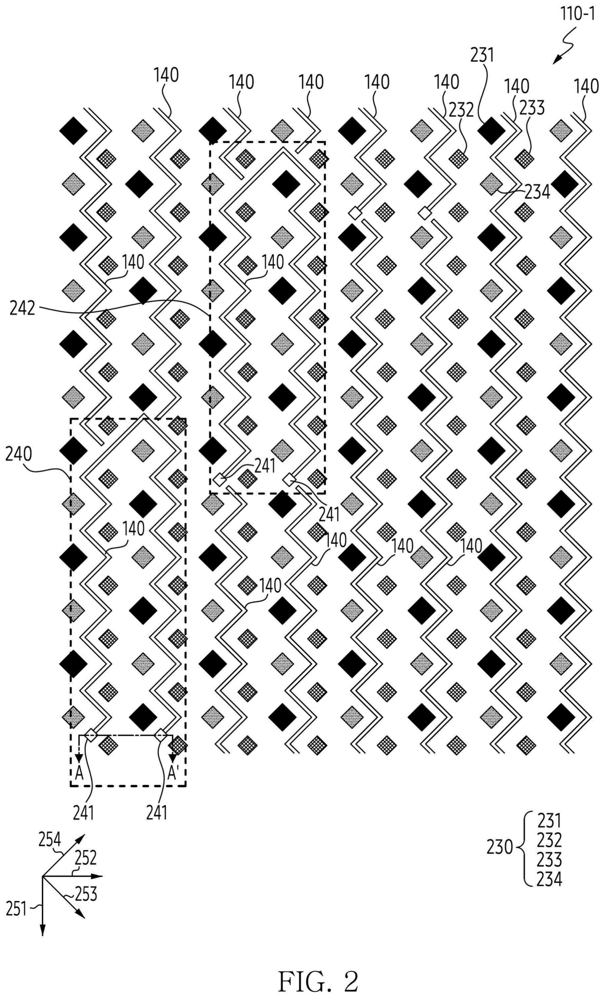

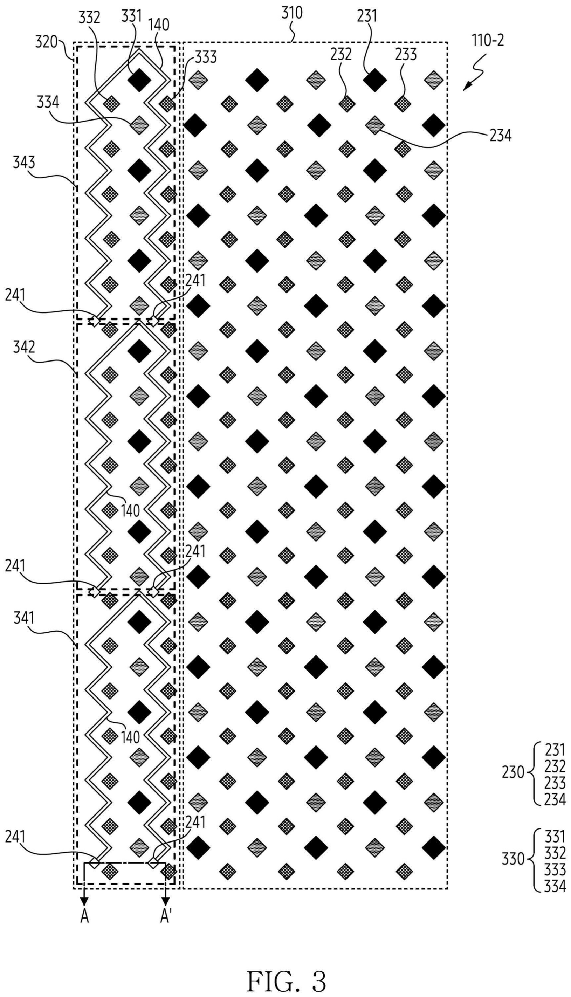

As described above, the conductive materials 140 may be embedded in the display panel 110 to sense at least partial deformation of the display panel 110. As a non-limiting example, the conductive materials 140 may include indium tin oxide (ITO) or conductive ink. As a non-limiting example, the conductive materials 140 may be embedded in the display panel 110 to more accurately sense at least partial deformation of the display panel 110. As a non-limiting example, the conductive materials 140 may be embedded in the display panel 110 to more quickly provide a response to at least partial deformation of the display panel 110. The conductive materials 140 may be formed in a pixel definition layer (PDL) of the display panel 110 or may be included in the PDL of the display panel 110. The PDL may sometimes be referred to as a dielectric layer. For example, the conductive materials 140 may be included in the PDL located in an active area. The active area may indicate an area including sub pixels usable (or available) for displaying an image. The active area may sometimes be referred to as a display area. For example, the conductive materials 140 may be included in the PDL located outside the active area (or in a non-active area). A display panel 110 including the conductive materials 140 in the PDL in the active area is exemplified in descriptions of FIG. 2, and a display panel 110 including the conductive materials 140 in the PDL outside the active area is exemplified in descriptions of FIG. 3.

FIG. 2 illustrates an example of a display panel including conductive materials in a pixel definition layer (PDL) within an active area.

FIG. 3 illustrates an example of a display panel including conductive materials in a PDL outside an active area.

Referring to FIG. 2, a display panel 110-1 may include sub pixels 230 (or an array of the sub pixels 230) respectively including light emitting elements (or light emitting diodes (e.g., organic light emitting diode (OLED))) in the active area. The sub pixels 230 may include sub pixels of a first set 231. Each of the sub pixels of the first set 231 may be configured to emit light having a first color (e.g., red). The sub pixels 230 may include sub pixels of a second set 232. Each of the sub pixels of the second set 232 may be configured to emit light having a second color (e.g., green). The sub pixels 230 may include sub pixels of a third set 233. Each of the sub pixels of the third set 233 may be configured to emit light having the second color. The sub pixels 230 may include sub pixels of a fourth set 234. Each of the sub pixels of the fourth set 234 may be configured to emit light having a third color (e.g., blue).

The display panel 110-1 may include a pixel definition layer (PDL) (not illustrated in FIG. 2) in the active area. The PDL may define a layout of the subpixels 230 (or a layout of the array). The PDL may sometimes be referred to as a dielectric layer.

The display panel 110-1 may include conductive materials 140 in the active area. The conductive materials 140 may be included in a portion of the PDL. For example, the conductive materials 140 may be formed in the portion of the PDL.

The conductive materials 140 may be uniformly distributed in the active area, as illustrated in FIG. 2. For example, in a case that the conductive materials 140 are included only in a portion of the active area, the portion of the active area may be viewable differently from another portion (or a remaining portion) of the active area due to the conductive materials 140. For example, the portion of the active area viewable differently from the another portion of the active area may decrease visibility (or conspicuity) of the display panel 110-1. For example, the conductive materials 140 may be uniformly distributed in the active area for visibility of the display panel 110-1. As a non-limiting example, the conductive materials 140 may be patterned in the portion of the PDL. As a non-limiting example, a portion of the conductive materials 140 patterned in the portion of the PDL may be disconnected from another portion of the conductive materials 140 patterned in the portion of the PDL. As a non-limiting example, at least one wiring from a portion of the conductive materials 140 patterned in the portion of the PDL may be electrically open, unlike at least one wiring from another portion of the conductive materials 140 patterned in the portion of the PDL. For example, a portion of the conductive materials 140 patterned in the portion of the PDL may be dummy.

As a non-limiting example, the conductive materials 140 may be patterned in the portion of the PDL, based on a first direction 251 (e.g., a vertical direction) and/or a second direction 252 (e.g., a horizontal direction). As a non-limiting example, the conductive materials 140 may be patterned in the portion of the PDL, based on a third direction 253 (e.g., a diagonal direction) and/or a fourth direction 254 (e.g., another diagonal direction). For example, the third direction 253 may be between the first direction 251 and the second direction 252 in a counterclockwise direction with respect to the first direction 251. For example, the fourth direction 254 may be between the first direction 251 and the second direction 252 in a clockwise direction with respect to the first direction 251. However, it is not limited thereto.

The conductive materials 140 may be used to sense at least partial deformation of the display panel 110-1. For example, a portion of the conductive materials 140 may be available to sense at least partial deformation of the display panel 110-1, and another portion (or a remaining portion) of the conductive materials 140 may be unavailable to sense at least partial deformation of the display panel 110-1. For example, in a case that a portion of the display panel 110-1 deformed based on the user input is fixed, the portion of the conductive materials 140 may be used to sense deformation of the portion of the display panel 110-1, unlike the another portion of the conductive materials 140. For example, the portion of the conductive materials 140 may be configured to be electrically connected to display driver circuitry 132 (not illustrated in FIG. 2), and the another portion of the conductive materials 140 may be electrically disconnected from the display driver circuitry 132.

As a non-limiting example, the conductive materials 140 located in an area 240 and an area 242 may include electrodes 241 (or a connection portion 241) connected to the display driver circuitry 132, and the conductive materials 140 located outside the area 240 and the area 242 may not include the electrodes 241. For example, the area 240 and the area 242 may correspond to the portion of the display panel 110-1 configured to be deformed based on the user input.

Referring to FIG. 3, the display panel 110-2 may include sub pixels 230 (or an array of the sub pixels 230) in a first part 310 of the display panel 110-2 including the active area. The sub pixels 230 may include sub pixels of a first set 231. Each of the sub pixels of the first set 231 may be configured to emit light having a first color (e.g., red). The sub pixels 230 may include sub pixels of a second set 232. Each of the sub pixels of the second set 232 may be configured to emit light having a second color (e.g., green). The sub pixels 230 may include sub pixels of a third set 233. Each of the sub pixels of the third set 233 may be configured to emit light having the second color. The sub pixels 230 may include sub pixels of a fourth set 234. Each of the sub pixels of the fourth set 234 may be configured to emit light having a third color (e.g., blue). However, it is not limited thereto. For example, the sub pixels 230 may include sub pixels of a first set configured to emit light having the first color, sub pixels of a second set configured to emit light having the second color, sub pixels of a third set configured to emit light having the third color, and sub pixels of a fourth set configured to emit light having a fourth color (e.g., white).

The display panel 110-2 may include a PDL (not illustrated in FIG. 3) in the first part 310. The PDL may define a layout of the sub pixels 230. The PDL may sometimes be referred to as a dielectric layer.

The display panel 110-2 may include dummy sub pixels 330 in a second part 320 of the display panel 110-2 including the non-active area. The dummy sub pixels 330 may indicate sub pixels unavailable for displaying an image. The dummy sub pixels 330 may indicate nonfunctional sub pixels. The dummy sub pixels 330 may indicate sub pixels located in a bezel (or a dead space) surrounding a periphery of the active area. For example, the dummy sub pixels 330 may include sub pixels of a first set 331, sub pixels of a second set 332, sub pixels of a third set 333, and/or sub pixels of a fourth set 334. However, it is not limited thereto. For example, each of the dummy sub pixels 330 (or at least a portion of the sub pixels 330) may include one or more TFTs without a light emitting element (e.g., OLED). For example, each of the dummy sub pixels 330 (or at least a portion of the sub pixels 330) may include another portion of the light emitting element and one or more TFTs without a portion (e.g., anode electrode) of the light emitting element.

As a non-limiting example, the dummy sub pixels 330 may be arranged to reduce a loading effect (or a macro loading effect).

The display panel 110-2 may include a PDL (not illustrated in FIG. 3) in the second part 320. The PDL may define a layout of the dummy sub pixels 330. The PDL may sometimes be referred to as a dielectric layer.

The display panel 110-2 may include conductive materials 140 in the second part 320. For example, the second part 320 may include the conductive materials 140, unlike the first part 310. The conductive materials 140 may be included in a portion of the PDL located in the second part 320. For example, the conductive materials 140 may be formed in a portion of the PDL located in the second part 320.

As a non-limiting example, the conductive materials 140 in the second part 320 may be distributed non-uniformly in the second part 320, unlike the conductive materials 140 included in the active area (e.g., the conductive materials 140 of FIG. 2). For example, since the conductive materials 140 in the second part 320 are invisible from a front surface of an electronic device including the display panel 110-2, the conductive materials 140 may be distributed non-uniformly in the second part 320.

For example, the conductive materials 140 may be used to sense at least partial deformation of the display panel 110-2. As a non-limiting example, since the conductive materials 140 may be distributed non-uniformly in the second part 320, all of the conductive materials 140 in the second part 320 may be configured to be electrically connected to the display driver circuitry 132 (not illustrated in FIG. 3).

As a non-limiting example, the conductive materials 140 located in an area 341, an area 342, and an area 343 may include electrodes 241 (or a connection portion 241) connected to the display driver circuitry 132. For example, the area 341, the area 342, and the area 343 may correspond to a portion of the display 110-2 configured to be deformed based on the user input.

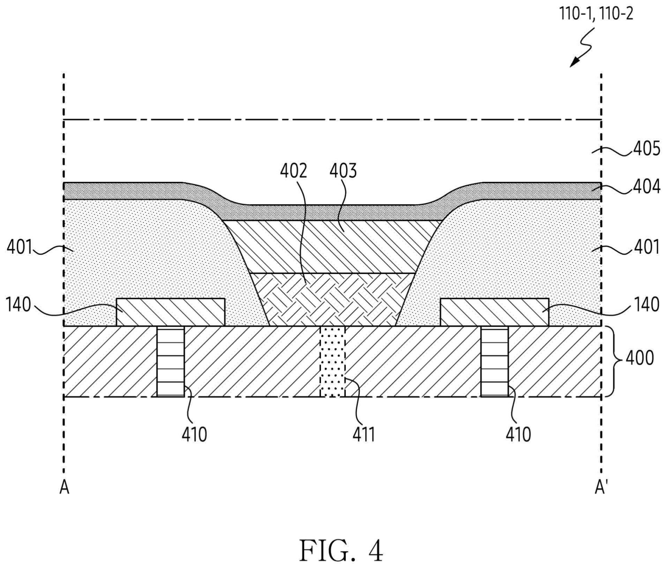

As described above, the conductive materials 140 may be included in a part of the display panel 110-1 including the active area or may be included in a part (e.g., the second part 320) of the display panel 110-2 including the non-active area. As described above, the conductive materials 140 may be formed in the PDL. The conductive materials 140 formed in the PDL are exemplified in descriptions of FIG. 4.

FIG. 4 is a cross-sectional view illustrating an example in which a display panel is cut along A-A' of FIG. 2 or A-A' of FIG. 3.

Referring to FIG. 4, a display panel (e.g., the display panel 110-1 or the display panel 110-2) may include a switch layer 400 (or a circuit layer 400) including thin film transistors (TFTs) configured to electrically connect display driver circuitry 132 to a first electrode layer 402, a PDL 401 disposed on the switch layer 400, the first electrode layer 402 disposed between the PDL 401 on the switch layer 400, a light emitting layer 403 disposed between the PDL 401 on the first electrode layer 402, and a second electrode layer 404 disposed over the PDL 401 and the light emitting layer 403. For example, the second electrode layer 404 may be surrounded by an encapsulation layer 405.

Although not illustrated in FIG. 4, the switch layer 400 may be disposed on a substrate or within the substrate. As a non-limiting example, the substrate may be formed of a bendable material such as polyimide (PI). For example, each of the TFTs may include a low temperature polycrystalline silicon (LTPS) TFT or a low temperature polycrystalline oxide (LTPO) TFT.

The first electrode layer 402 may include an anode printed in the first electrode layer 402.

The light emitting layer 403 may cover the anode printed in the first electrode layer 402. For example, a portion of the light emitting layer 403 may be contacted on the first electrode layer 402. For example, the light emitting layer 403 may be interposed between the first electrode layer 402 and the second electrode layer 404.

The second electrode layer 404 may include a cathode.

For example, the first electrode layer 402, the light emitting layer 403, and the second electrode layer 404 may form the light emitting diodes exemplified in the descriptions of FIG. 2.

The PDL 401 may be located along a periphery of the first electrode layer 402. For example, the PDL 401 may contact a side surface of the first electrode layer 402. For example, the PDL 401 may at least partially surround the first electrode layer 402.

The PDL 401 may be located along a periphery of the light emitting layer 403. For example, the PDL 401 may contact a side surface of the light emitting layer 403. For example, the PDL 401 may at least partially surround the light emitting layer 403.

The PDL 401 may further include the conductive materials 140. At least a portion of the conductive materials 140 may be configured to be electrically connected to the display driver circuitry 132 through a wiring 410 (or electrodes 241) formed in the switch layer 400. For example, the first electrode layer 402 in the active area may be connected to the TFTs through at least one wiring 411.

As a non-limiting example, since the conductive materials 140 are included in the PDL 401, the conductive materials 140 may more accurately sense at least partial deformation of the display panel 110 (e.g., the display panel 110-1 or the display panel 110-2). As a non-limiting example, since the conductive materials 140 are included in the PDL 401, the conductive materials 140 may more quickly provide a response to at least partial deformation of the display panel 110.

For example, the display driver circuitry 132 may provide or transmit, to the display panel 110, first signals for displaying an image on the display panel 110 and at least one second signal for sensing at least partial deformation of the display panel 110 by using the conductive materials 140. The first signals may be provided through first wirings connecting the display driver circuitry 132 and the display panel 110, and the at least one second signal may be provided through at least one second wiring different from the first wirings. For example, the first signals may be provided to the sub pixels 230 to apply a data voltage. For example, the at least one second signal may be provided to at least a portion of the conductive materials 140 to sense at least partial deformation of the display panel 110.

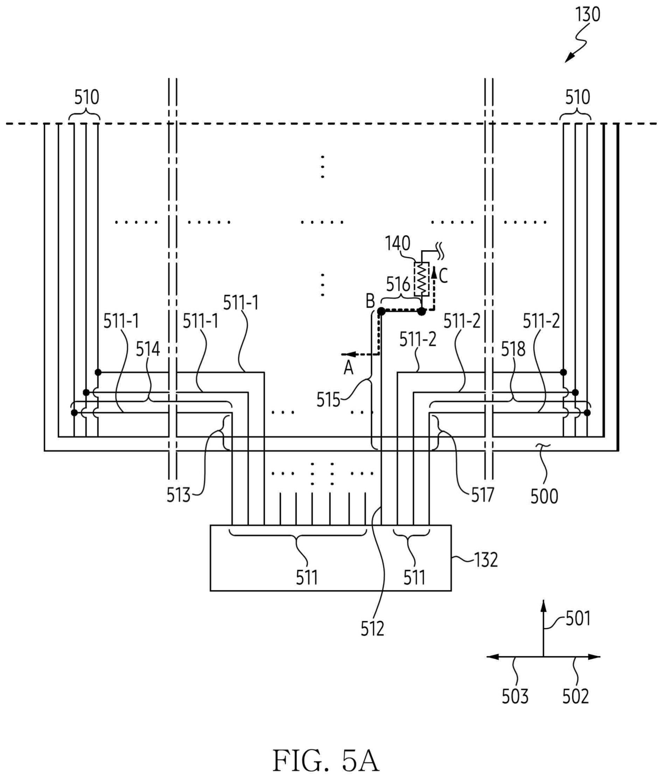

As a non-limiting example, a size (or a width) (or a length) of the display driver circuitry 132 may be smaller than a size (or a width) (or a length) of the display panel 110. A difference between the size of the display driver circuitry 132 and the size of the display panel 110 may increase a size of the bezel (or the dead space). For example, a direction in which at least a portion of the first wirings extend may be changed in the display panel 110 to reduce the size of the bezel. For example, a direction in which the at least one second wiring extends may be changed in the display panel 110 to reduce the size of the bezel. The at least a portion of the first wirings and the at least one second wiring are exemplified in descriptions of FIG. 5A.

FIG. 5A illustrates an example of a connection relationship between display driver circuitry and a display panel.

Referring to FIG. 5A, the display panel 110 may include wirings 510 formed in a first direction 501 and connected to the sub pixels 230 (not illustrated in FIG. 5A).

For example, the display 130 may include first wirings 511 extending from the display driver circuitry 132 to the wirings 510 and at least one second wiring 512 extending from the display driver circuitry 132 to the conductive materials 140.

For example, a portion 511-1 of the first wirings 511 may include a part 513 extending in the first direction 501 in the display panel 110 and a part 514 extending from the part 513 in a third direction 503 perpendicular to the first direction 501, to reduce a size of a bezel 500. For example, a portion 511-2 of the first wirings 511 may include a part 517 extending in the first direction 501 in the display panel 110 and a part 518 extending from the part 517 in a second direction 502 perpendicular to the first direction 501 and opposite to the third direction 503, to reduce the size of the bezel 500.

For example, the at least one second wiring 512 may include a part 515 extending in the first direction 501 and a part 516 extending from the part 515 to a conductive portion 140 (or an electrode of the conductive portion 140) in the second direction 502.

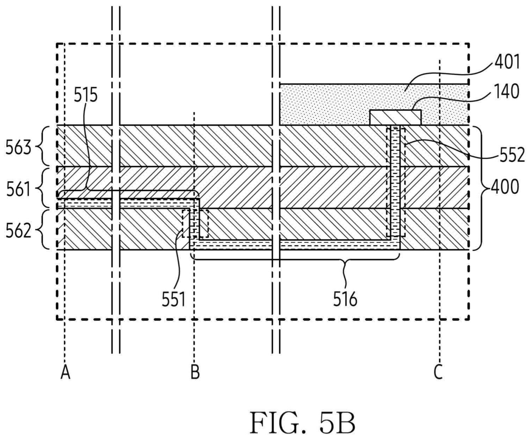

As a non-limiting example, a first layer in which the part 515 is formed may be different from a second layer in which the part 516 is formed, to reduce interference to another signal and/or interference from another signal. The first layer and the second layer are exemplified in descriptions of FIG. 5B.

FIG. 5B is a cross-sectional view illustrating an example in which a display panel is cut along A-B-C of FIG. 5A.

Referring to FIG. 5B, a switch layer 400 may include a first layer 561 and a second layer 562 below the first layer 561. As a non-limiting example, at least a portion of the first layer 561 and/or at least a portion of the second layer 562 may be used to arrange wirings for providing a data voltage.

The part 515 of the at least one second wiring 512 may be formed in the first layer 561. The part 516 of the at least one second wiring 512 may be formed in the second layer 562. For example, since the part 515 is formed in the first layer 561 and the part 516 is formed in the second layer 562, the at least one second wiring 512 may include a via part 551 connecting the part 515 and the part 516. For example, the conductive materials 140 may include a via part 552 connecting the part 516 to the conductive materials 140. As a non-limiting example, a portion of the via part 552 may correspond to the wiring 410.

As a non-limiting example, the switch layer 400 may further include a third layer 563 on the first layer 461. For example, a portion of the via part 552 may be formed in the third layer 563.

For example, the display driver circuitry 132 may obtain data regarding a state of at least a portion of the conductive materials 140 exemplified above and may transmit the data to the processor 131. For example, the processor 131 may execute a function corresponding to at least partial deformation of the display panel 110 by the user input, based on the data received from the display driver circuitry 132. For example, the data may indicate a resistance value of the at least a portion of the conductive materials 140. For example, a shape of the conductive materials 140 may be changed according to the at least partial deformation of the display panel 110. For example, the conductive materials 140 may have different resistance values according to a shape. For example, in a case that the conductive materials 140 have a first length, a resistance value of the conductive materials 140 may be a first value, and in a case that the conductive materials 140 have a second length changed from the first length, a resistance value of the conductive materials 140 may be a second value. As a non-limiting example, the data may be configured with a voltage value indicating the resistance value of the at least a portion of the conductive materials 140.

For example, the display driver circuitry 132 may obtain the data based on applying a voltage to the at least a portion of the conductive materials 140 and may transmit the data to the processor 131.

For example, a location in the display panel 110 in which the conductive materials 140 are included may be changed according to a type of an electronic device including the display panel 110.

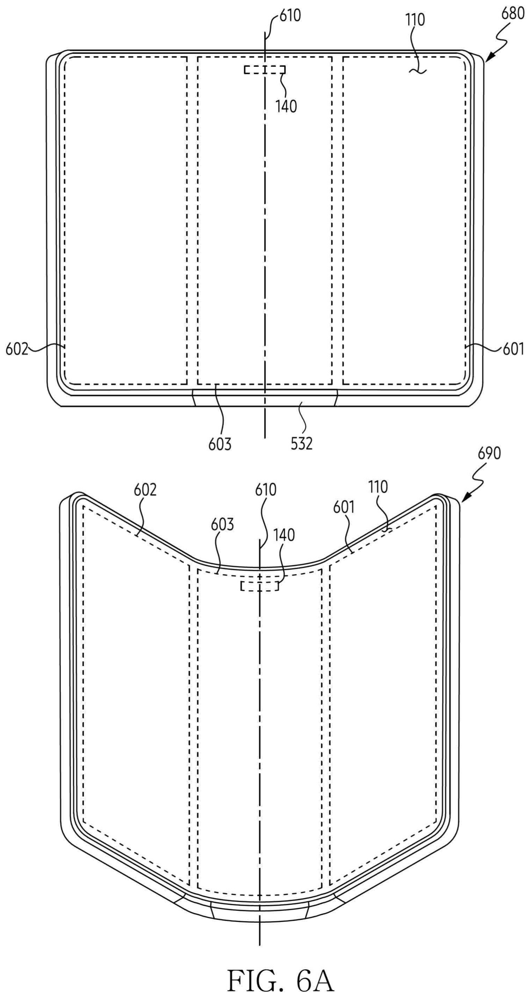

For example, in a case that the electronic device including the display panel 110 is a foldable electronic device, the conductive materials 140 may be located in a folding part of the display panel 110. The conductive materials 140 located in the folding part are exemplified in descriptions of FIG. 6A.

FIG. 6A illustrates an example of a foldable electronic device having a display panel including conductive materials in a PDL.

Referring to FIG. 6A, a display panel 110 in a foldable electronic device may include a first planar part 601, a second planar part 602 facing the first planar part 601 in a folded state of the foldable electronic device, and a folding part 603 located between the first planar part 601 and the second planar part 602 to be bent between an unfolded state (e.g., a state 680) of the foldable electronic device and the folded state. For example, the folding part 603 may connect the first planar part 601 and the second planar part 602.

For example, the at least a portion of the conductive materials 140 may be disposed in the folding part 603. For example, the at least a portion of the conductive materials 140 may be disposed across an axis 610 for rotation of the second planar part 602 with respect to the first planar part 601. For example, the conductive materials 140 may be disposed across the axis 610 so that a resistance value of the at least a portion of the conductive materials 140 is changed.

For example, the conductive materials 140 may have a first resistance value in a state 680 corresponding to the unfolded state. For example, the conductive materials 140 may have a second resistance value different from the first resistance value (e.g., the second resistance value higher than the first resistance value) in a state 690 corresponding to a partially folded state between the folded state and the unfolded state.

For example, the display driver circuitry 132 may obtain the data indicating the first resistance value (or the data indicating a first voltage value corresponding to the first resistance value) and may transmit the data to the processor 131. The processor 131 may recognize the state 680 based on the data. For example, the display driver circuitry 132 may obtain the data indicating the second resistance value (or the data indicating a second voltage value corresponding to the second resistance value) and may transmit the data to the processor 131. The processor 131 may recognize the state 690 based on the data. For example, the processor 131 may obtain, from the data, information regarding an angle between the planar part 601 and the planar part 602.

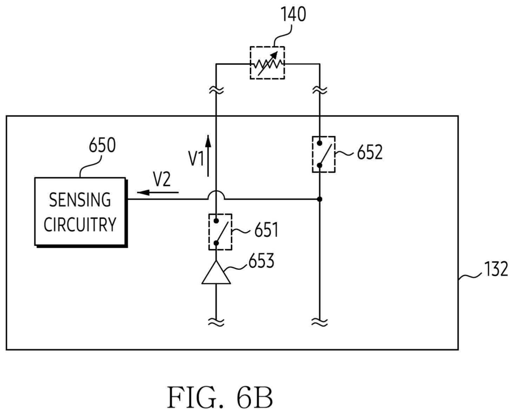

For example, the display driver circuitry 132 may obtain the data by applying a first voltage to the conductive materials 140 and measuring or obtaining a second voltage indicating a resistance value of the conductive materials 140. Obtaining the data is exemplified in a description of FIG. 6B.

FIG. 6B illustrates components of display driver circuitry in a foldable electronic device for obtaining data regarding a state of at least a portion of conductive materials.

Referring to FIG. 6B, the display driver circuitry 132 may include sensing circuitry 650, a switch 651, a switch 652, and a power amplifier (PA) 653.

For example, the switch 651 may be configured to connect the PA 653 and the conductive materials 140 or disconnect the conductive materials 140 from the PA 653. For example, the switch 652 may be configured to connect the sensing circuitry 650 and the conductive materials 140 or disconnect the conductive materials 140 from the sensing circuitry 650.

For example, the display driver circuitry 132 may control the switch 651 to connect the PA 653 and the conductive materials 140 for applying a first voltage V1 obtained using the PA 653 to the conductive materials 140. For example, the display driver circuitry 132 may control the switch 652 to connect the sensing circuitry 650 and the conductive materials 140 for obtaining a second voltage V2 indicating a resistance value of the conductive materials 140, while the PA 653 is connected to the conductive materials 140 (or while the first voltage V1 is applied to the conductive materials 140). For example, the display driver circuitry 132 may transmit, to the processor 131, data indicating a second voltage V2 obtained through the sensing circuitry 650.

For example, the display driver circuitry 132 may periodically control the switch 651 and the switch 652. For example, a period of a pulse signal provided to the switch 651 for controlling the switch 651 may correspond to a period of a pulse signal provided to the switch 652 for controlling the switch 652. For example, a duty cycle of a pulse signal provided to the switch 651 for controlling the switch 651 may correspond to a duty cycle of a pulse signal provided to the switch 652 for controlling the switch 652. For example, an offset of a pulse signal provided to the switch 651 for controlling the switch 651 may correspond to an offset of a pulse signal provided to the switch 652 for controlling the switch 652.

Although FIG. 6B illustrates the conductive materials 140 implemented with a single variable resistor, it is merely exemplary. For example, the conductive materials 140 may be implemented with a plurality of resistors. For example, the plurality of resistors may include one or more variable resistors. For example, the plurality of resistors may form at least a portion of a bridge circuit (e.g., a Wheatstone bridge circuit). For example, the bridge circuit may be used for compensating a change in a resistance value according to temperature.

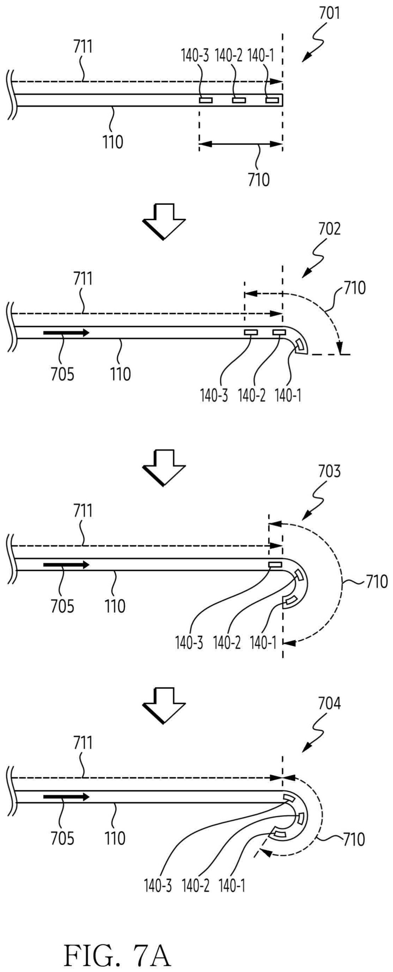

For example, in a case that an electronic device including the display panel 110 is a rollable electronic device, the at least a portion of the conductive materials 140 may be located in a part rollable into a housing of the electronic device. The conductive materials 140 disposed within the part are exemplified in the description of FIG. 7A.

FIG. 7A illustrates an example of a rollable (or slidable) electronic device having a display panel including conductive materials in a PDL.

Referring to FIG. 7A, a display panel 110 in a rollable electronic device may include a part 710 rollable into a housing (not illustrated in FIG. 7A) of the rollable electronic device for change of size of an area that is visible from a front surface of the housing. For example, a conductive material 140-1, a conductive material 140-2, and a conductive material 140-3 may be disposed in the part 710. For example, the conductive material 140-1, the conductive material 140-2, and the conductive material 140-3 may be disposed along a direction 705 in which the part 710 (or the display panel 110) is moved into the housing.

For example, in a state 701 in which the part 710 is located outside the housing, each of the conductive material 140-1, the conductive material 140-2, and the conductive material 140-3 may have a first resistance value. For example, in a state 702 in which the part 710 is partially rolled, the conductive material 140-1 may have a second resistance value different from the first resistance value, and each of the conductive material 140-2 and the conductive material 140-3 may have the first resistance value. For example, in a state 703 in which the part 710 is further partially rolled, each of the conductive material 140-1 and the conductive material 140-2 may have the second resistance value, and the conductive material 140-3 may have the first resistance value. For example, in a state 704 in which the part 710 is fully rolled, each of the conductive material 140-1, the conductive material 140-2, and the conductive material 140-3 may have the second resistance value.

The above descriptions assume that the part 710 that is partially rolled has one (or single) curvature, but it is merely exemplary. The part 710 that is partially rolled may have various curvatures. For example, in a case that the part 710 that is partially rolled has various curvatures, a resistance value of the conductive material 140-1 in the state 703 may be different from a resistance value of the conductive material 140-2 in the state 703. For example, in a case that the part 710 that is partially rolled has various curvatures, a resistance value of the conductive material 140-1 in the state 704, a resistance value of the conductive material 140-2 in the state 704, and a resistance value of the conductive material 140-3 in the state 704 may be different.

For example, in the state 701, the display driver circuitry 132 may obtain data indicating the first resistance value as data regarding a state of the conductive material 140-1, obtain data indicating the first resistance value as data regarding a state of the conductive material 140-2, and obtain data indicating the first resistance value as data regarding a state of the conductive material 140-3. For example, the display driver circuitry 132 may transmit, to the processor 131, data indicating the first resistance value as data regarding a state of the conductive material 140-1, transmit to the processor 131, data indicating the first resistance value as data regarding a state of the conductive material 140-2, and transmit, to the processor 131, data indicating the first resistance value as data regarding a state of the conductive material 140-3. The processor 131 may recognize the state 701, based on data indicating the first resistance value received as data regarding a state of the conductive material 140-1, data indicating the first resistance value received as data regarding a state of the conductive material 140-2, and data indicating the first resistance value received as data regarding a state of the conductive material 140-3. For example, the processor 131 may recognize a size of an area 711 visible from a front surface of the housing, based on data indicating the first resistance value received as data regarding a state of the conductive material 140-1, data indicating the first resistance value received as data regarding a state of the conductive material 140-2, and data indicating the first resistance value received as data regarding a state of the conductive material 140-3.

For example, in the state 702, the display driver circuitry 132 may obtain data indicating the second resistance value as data regarding a state of the conductive material 140-1, obtain data indicating the first resistance value as data regarding a state of the conductive material 140-2, and obtain data indicating the first resistance value as data regarding a state of the conductive material 140-3. For example, the display driver circuitry 132 may transmit, to the processor 131, data indicating the second resistance value as data regarding a state of the conductive material 140-1, transmit to the processor 131, data indicating the first resistance value as data regarding a state of the conductive material 140-2, and transmit, to the processor 131, data indicating the first resistance value as data regarding a state of the conductive material 140-3. The processor 131 may recognize the state 702, based on data indicating the second resistance value received as data regarding a state of the conductive material 140-1, data indicating the first resistance value received as data regarding a state of the conductive material 140-2, and data indicating the first resistance value received as data regarding a state of the conductive material 140-3. For example, the processor 131 may recognize a size of an area 711 visible from a front surface of the housing, based on data indicating the second resistance value received as data regarding a state of the conductive material 140-1, data indicating the first resistance value received as data regarding a state of the conductive material 140-2, and data indicating the first resistance value received as data regarding a state of the conductive material 140-3.

For example, in the state 703, the display driver circuitry 132 may obtain data indicating the second resistance value as data regarding a state of the conductive material 140-1, obtain data indicating the second resistance value as data regarding a state of the conductive material 140-2, and obtain data indicating the first resistance value as data regarding a state of the conductive material 140-3. For example, the display driver circuitry 132 may transmit, to the processor 131, data indicating the second resistance value as data regarding a state of the conductive material 140-1, transmit to the processor 131, data indicating the second resistance value as data regarding a state of the conductive material 140-2, and transmit, to the processor 131, data indicating the first resistance value as data regarding a state of the conductive material 140-3. The processor 131 may recognize the state 703, based on data indicating the second resistance value received as data regarding a state of the conductive material 140-1, data indicating the second resistance value received as data regarding a state of the conductive material 140-2, and data indicating the first resistance value received as data regarding a state of the conductive material 140-3. For example, the processor 131 may recognize a size of an area 711 visible from a front surface of the housing, based on data indicating the second resistance value received as data regarding a state of the conductive material 140-1, data indicating the second resistance value received as data regarding a state of the conductive material 140-2, and data indicating the first resistance value received as data regarding a state of the conductive material 140-3.

For example, in the state 704, the display driver circuitry 132 may obtain data indicating the second resistance value as data regarding a state of the conductive material 140-1, obtain data indicating the second resistance value as data regarding a state of the conductive material 140-2, and obtain data indicating the second resistance value as data regarding a state of the conductive material 140-3. For example, the display driver circuitry 132 may transmit, to the processor 131, data indicating the second resistance value as data regarding a state of the conductive material 140-1, transmit to the processor 131, data indicating the second resistance value as data regarding a state of the conductive material 140-2, and transmit, to the processor 131, data indicating the second resistance value as data regarding a state of the conductive material 140-3. The processor 131 may recognize the state 704, based on data indicating the second resistance value received as data regarding a state of the conductive material 140-1, data indicating the second resistance value received as data regarding a state of the conductive material 140-2, and data indicating the second resistance value received as data regarding a state of the conductive material 140-3. For example, the processor 131 may recognize a size of an area 711 visible from a front surface of the housing, based on data indicating the second resistance value received as data regarding a state of the conductive material 140-1, data indicating the second resistance value received as data regarding a state of the conductive material 140-2, and data indicating the second resistance value received as data regarding a state of the conductive material 140-3.

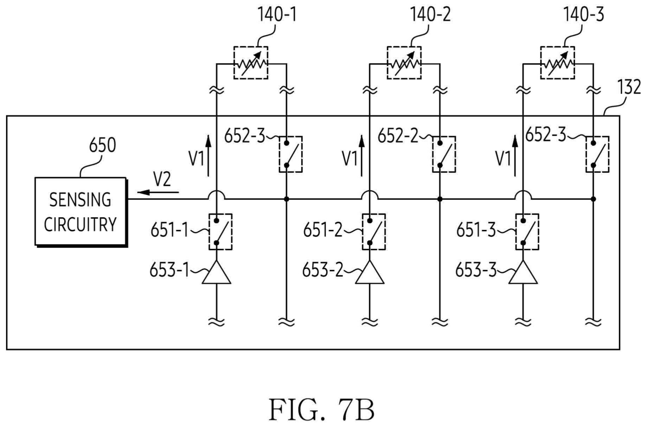

For example, the display driver circuitry 132 may obtain data regarding the conductive material 140-1, data regarding the conductive material 140-2, and data regarding the conductive material 140-3, by applying a first voltage to each of the conductive material 140-1, the conductive material 140-2, and the conductive material 140-3 and measuring or obtaining a second voltage indicating a resistance value of each of the conductive material 140-1, the conductive material 140-2, and the conductive material 140-3. Obtaining the data regarding the conductive material 140-1, the data regarding the conductive material 140-2, and the data regarding the conductive material 140-3 may be exemplified in a description of FIG. 7B.

FIG. 7B illustrates components of display driver circuitry in a rollable electronic device for obtaining data regarding a state of at least a portion of conductive materials.

Referring to FIG. 7B, the display driver circuitry 132 may include sensing circuitry 650, a switch 651-1, a switch 651-2, a switch 651-3, a switch 652-1, a switch 652-2, a switch 652-3, a PA 653-1, a PA 653-2, and a PA 653-3.

For example, the switch 651-1 may be configured to connect the PA 653-1 and the conductive material 140-1 or disconnect the conductive material 140-1 from the PA 653-1. For example, the switch 652-1 may be configured to connect the sensing circuitry 650 and the conductive material 140-1 or disconnect the conductive material 140-1 from the sensing circuitry 650.

For example, the switch 651-2 may be configured to connect the PA 653-2 and the conductive material 140-2 or disconnect the conductive material 140-2 from the PA 653-2. For example, the switch 652-2 may be configured to connect the sensing circuitry 650 and the conductive material 140-2 or disconnect the conductive material 140-2 from the sensing circuitry 650.

For example, the switch 651-3 may be configured to connect the PA 653-3 and the conductive material 140-3 or disconnect the conductive material 140-3 from the PA 653-3. For example, the switch 652-3 may be configured to connect the sensing circuitry 650 and the conductive material 140-3 or disconnect the conductive material 140-3 from the sensing circuitry 650.

For example, the display driver circuitry 132 may control the switch 651-1 to connect the PA 653-1 and the conductive material 140-1 to apply a first voltage V1 obtained using the PA 653-1 to the conductive material 140-1. For example, the display driver circuitry 132 may control the switch 652-1 to connect the conductive material 140-1 and the sensing circuitry 650 to obtain a second voltage V2 indicating a resistance value of the conductive material 140-1, while the PA 653-1 is connected to the conductive material 140-1 (or while the first voltage V1 is applied to the conductive material 140-1). For example, the display driver circuitry 132 may transmit, to the processor 131, data indicating the second voltage V2 obtained through the sensing circuitry 650 as data regarding a state of the conductive material 140-1.

For example, the display driver circuitry 132 may control the switch 651-2 to connect the PA 653-2 and the conductive material 140-2 to apply a first voltage V1 obtained using the PA 653-2 to the conductive material 140-2. For example, the display driver circuitry 132 may control the switch 652-2 to connect the conductive material 140-2 and the sensing circuitry 650 to obtain a second voltage V2 indicating a resistance value of the conductive material 140-2, while the PA 653-2 is connected to the conductive material 140-2 (or while the first voltage V1 is applied to the conductive material 140-2). For example, the display driver circuitry 132 may transmit, to the processor 131, data indicating the second voltage V2 obtained through the sensing circuitry 650 as data regarding a state of the conductive material 140-2.

For example, the display driver circuitry 132 may control the switch 651-3 to connect the PA 653-3 and the conductive material 140-3 to apply a first voltage V1 obtained using the PA 653-3 to the conductive material 140-3. For example, the display driver circuitry 132 may control the switch 652-3 to connect the conductive material 140-3 and the sensing circuitry 650 to obtain a second voltage V2 indicating a resistance value of the conductive material 140-3, while the PA 653-3 is connected to the conductive material 140-3 (or while the first voltage V1 is applied to the conductive material 140-3). For example, the display driver circuitry 132 may transmit, to the processor 131, data indicating the second voltage V2 obtained through the sensing circuitry 650 as data regarding a state of the conductive material 140-3.

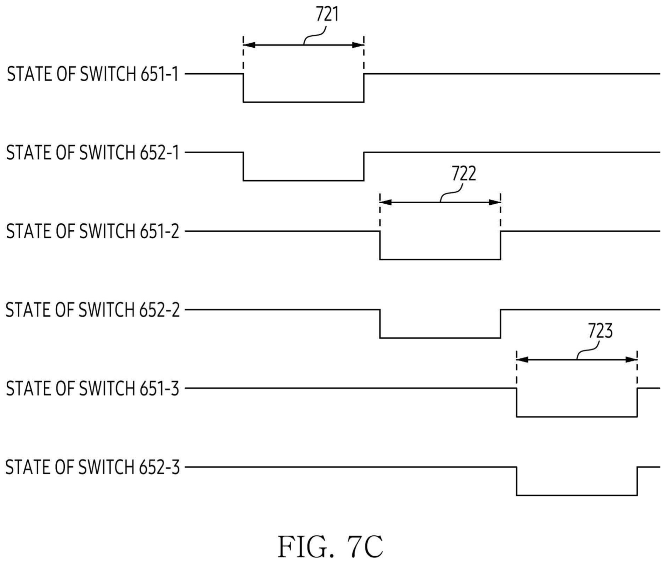

The control of the switch 651-1, the control of the switch 651-2, the control of the switch 651-3, the control of the switch 652-1, the control of the switch 652-2, and the control of the switch 652-3 may be exemplified in a description of FIG. 7C.

FIG. 7C illustrates an exemplary method of controlling switches of FIG. 7B.

Referring to FIG. 7C, in a time interval 721, the display driver circuitry 132 may control the switch 651-1 to connect the conductive material 140-1 to the PA 653-1 and may control the switch 652-1 to connect the sensing circuitry 650 to the conductive material 140-1.

For example, in a time interval 722 subsequent to the time interval 721, the display driver circuitry 132 may control the switch 651-2 to connect the conductive material 140-2 to the PA 653-2 and may control the switch 652-2 to connect the sensing circuitry 650 to the conductive material 140-2. For example, a length of the time interval 722 may correspond to a length of the time interval 721.

For example, in a time interval 723 subsequent to the time interval 722, the display driver circuitry 132 may control the switch 651-3 to connect the conductive material 140-3 to the PA 653-3 and may control the switch 652-3 to connect the sensing circuitry 650 to the conductive material 140-3. For example, a length of the time interval 723 may correspond to a length of the time interval 721.

For example, the display driver circuitry 132 may periodically control the switch 651-1, the switch 651-2, the switch 651-3, the switch 652-1, the switch 652-2, and the switch 652-3.

For example, a period of a pulse signal provided to the switch 651-1 to control the switch 651-1 may correspond to a period of a pulse signal provided to the switch 652-1 for controlling the switch 652-1. For example, a duty cycle of a pulse signal provided to the switch 651-1 for controlling the switch 651-1 may correspond to a duty cycle of a pulse signal provided to the switch 652-1 for controlling the switch 652-1. For example, an offset of a pulse signal provided to the switch 651-1 for controlling the switch 651-1 may correspond to an offset of a pulse signal provided to the switch 652-1 for controlling the switch 652-1.

For example, a period of a pulse signal provided to the switch 651-2 for controlling the switch 651-2 may correspond to a period of a pulse signal provided to the switch 652-2 for controlling the switch 652-2. For example, a period of a pulse signal provided to the switch 651-2 for controlling the switch 651-2 may correspond to a period of a pulse signal provided to the switch 651-1 for controlling the switch 651-1. For example, a duty cycle of a pulse signal provided to the switch 651-2 for controlling the switch 651-2 may correspond to a duty cycle of a pulse signal provided to the switch 652-2 for controlling the switch 652-2. For example, a duty cycle of a pulse signal provided to the switch 651-2 for controlling the switch 651-2 may correspond to a duty cycle of a pulse signal provided to the switch 651-1 for controlling the switch 651-1. For example, an offset of a pulse signal provided to the switch 651-2 for controlling the switch 651-2 may correspond to an offset of a pulse signal provided to the switch 652-2 for controlling the switch 652-2. For example, an offset of a pulse signal provided to the switch 651-2 for controlling the switch 651-2 may differ from an offset of a pulse signal provided to the switch 651-1 for controlling the switch 651-1.

For example, a period of a pulse signal provided to the switch 651-3 for controlling the switch 651-3 may correspond to a period of a pulse signal provided to the switch 652-3 for controlling the switch 652-3. For example, a period of a pulse signal provided to the switch 651-3 for controlling the switch 651-3 may correspond to a period of a pulse signal provided to the switch 651-1 for controlling the switch 651-1. For example, a duty cycle of a pulse signal provided to the switch 651-3 for controlling the switch 651-3 may correspond to a duty cycle of a pulse signal provided to the switch 652-3 for controlling the switch 652-3. For example, a duty cycle of a pulse signal provided to the switch 651-3 for controlling the switch 651-3 may correspond to a duty cycle of a pulse signal provided to the switch 651-1 for controlling the switch 651-1. For example, an offset of a pulse signal provided to the switch 651-3 for controlling the switch 651-3 may correspond to an offset of a pulse signal provided to the switch 652-3 for controlling the switch 652-3. For example, an offset of a pulse signal provided to the switch 651-3 for controlling the switch 651-3 may differ from an offset of a pulse signal provided to the switch 651-1 for controlling the switch 651-1. For example, an offset of a pulse signal provided to the switch 651-3 for controlling the switch 651-3 may differ from an offset of a pulse signal provided to the switch 651-2 for controlling the switch 651-2.

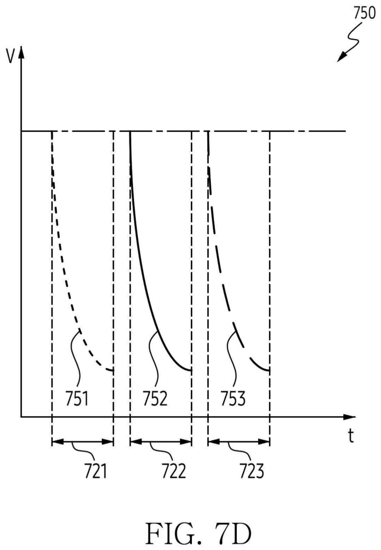

For example, the display driver circuitry 132 may transmit, to the processor 131, data indicating a second voltage V2 obtained through the sensing circuitry 650 within the time interval 721 as data regarding a state of the conductive material 140-1. For example, the display driver circuitry 132 may transmit, to the processor 131, data indicating a second voltage V2 obtained through the sensing circuitry 650 within the time interval 722 as data regarding a state of the conductive material 140-2. For example, the display driver circuitry 132 may transmit, to the processor 131, data indicating a second voltage V2 obtained through the sensing circuitry 650 within the time interval 723 as data regarding a state of the conductive material 140-3. The data indicating the second voltage V2 obtained within the time interval 721, the data indicating the second voltage V2 obtained within the time interval 722, and the data indicating the second voltage V2 obtained within the time interval 723 are exemplified in a description of FIG. 7D.

FIG. 7D illustrates an example of data regarding a state of at least a portion of conductive materials.

Referring to FIG. 7D, a horizontal axis of a chart 750 indicates time, and a vertical axis of the chart 750 indicates voltage. A line 751 in the chart 750 indicates data indicating a second voltage V2 obtained within a time interval 721, a line 752 in the chart 750 indicates data indicating a second voltage V2 obtained within a time interval 722, and a line 753 in the chart 750 indicates data indicating a second voltage V2 obtained within a time interval 723.

For example, the processor 131 may recognize a state 704 changed from a state 701 through a state 702 and a state 703, based on a change of data within the time interval 721 indicated by the line 751, a change of data within the time interval 722 indicated by the line 752, and a change of data within the time interval 723 indicated by the line 753.

The above descriptions illustrate an example in which the change of data within the time interval 721 indicated by the line 751, the change of data within the time interval 722 indicated by the line 752, and the change of data within the time interval 723 indicated by the line 753 are the same, but it is merely exemplary. For example, in a case that the part 710 that is partially rolled has various curvatures, the change of data within the time interval 721 indicated by the line 751, the change of data within the time interval 722 indicated by the line 752, and the change of data within the time interval 723 indicated by the line 753 may be different.

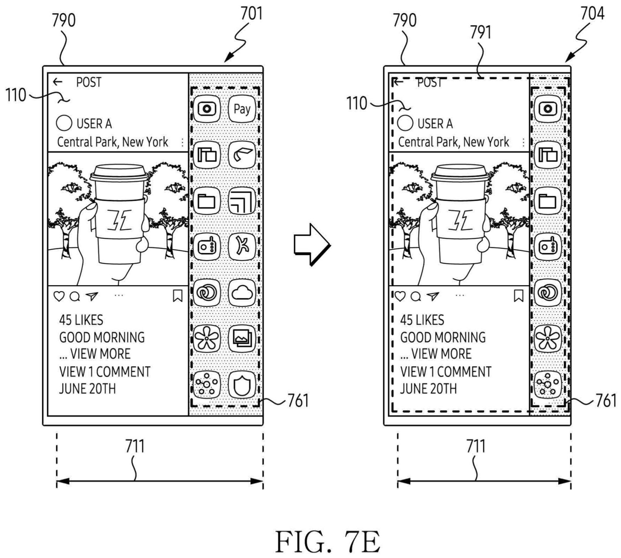

For example, the processor 131 may execute a function corresponding to the state 704, based on a recognition of the state 704. An example of the function is exemplified in a description of FIG. 7E.

FIG. 7E illustrates an example of a function executed based on data regarding a state of at least a portion of conductive materials.

Referring to FIG. 7E, the processor 131 may sense, detect, recognize, or identify a state 704 changed from a state 701, based at least in part on operations exemplified in the descriptions of FIGS. 7A to 7D. For example, the processor 131 may execute the function by obtaining or generating a screen 791 corresponding to a size of an area 711 visible from a front surface of a housing 790 in the state 704 and transmitting, to the display driver circuitry 132, information regarding the screen 791 for displaying the screen 791.

For example, the processor 131 may transmit, to the display driver circuitry 132, information regarding the screen 791, to display a panel 761 (e.g., an edge panel) having a second size smaller than a first size of the bar-shaped panel 761 that was displayed on the display panel 110 in the state 701.

As a non-limiting example, the processor 131 may transmit, to the display driver circuitry 132, information regarding an image to be displayed on a portion of the display panel 110 that is invisible from the front surface of the housing 790, in the state 704 changed from the state 701. For example, the information regarding the image may be included within the information regarding the screen 791. For example, the information regarding the image may be transmitted together with the information regarding the screen 791. For example, the image may be displayed on the portion of the display panel 110 to reduce a probability in which an afterimage occurs within the portion of the display panel 110 when the state 704 is changed to the state 701.

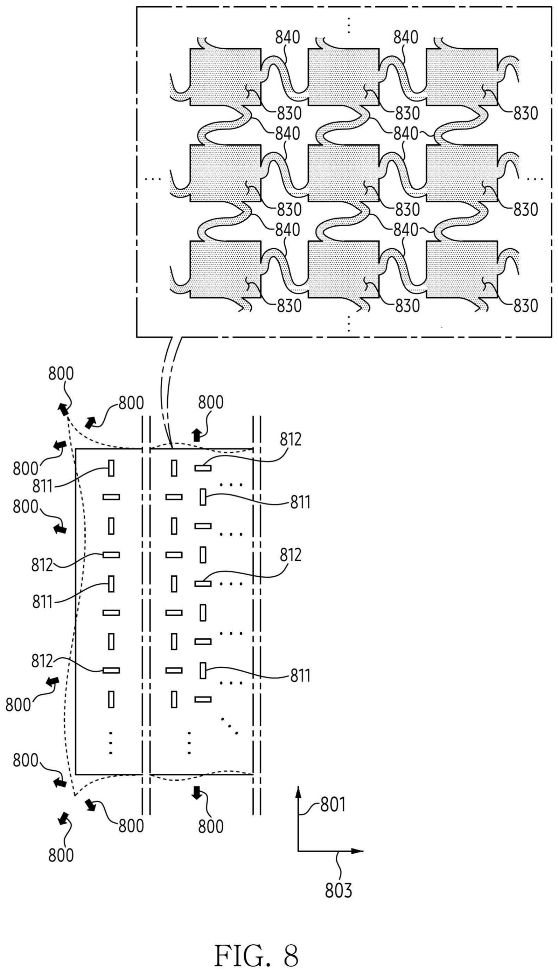

For example, in a case that the electronic device including the display panel 110 is a stretchable electronic device, the conductive materials 140 configured to be electrically connected to the display driver circuitry 132 may be uniformly distributed within the display panel 110. For example, the conductive materials 140 may be patterned within the display panel 110. The conductive materials 140 patterned within the display panel 110 are exemplified in a description of FIG. 8.

FIG. 8 illustrates an example of conductive materials included in a stretchable display panel.

Referring to FIG. 8, in a display panel 110 within a stretchable electronic device, a part that is at least partially deformed may not be fixed. For example, the display panel 110 may be randomly deformed or stretched, as indicated by arrows 800. For example, the display panel 110 may include conductive materials 140 of a first set 811 having a longitudinal direction corresponding to a direction 801, and conductive materials 140 of a second set 812 having a longitudinal direction corresponding to a direction 803 perpendicular to the direction 801. For example, the conductive materials 140 of the first set 811 may be disposed between the conductive materials 140 of the second set 812. For example, the conductive materials 140 of the first set 811 and the conductive materials 140 of the second set 812 may be patterned. For example, the conductive materials 140 of the first set 811 and the conductive materials 140 of the second set 812 may form a pattern.

As a non-limiting example, a portion of the display panel 110 may be rigid, and another portion of the display panel 110 may be flexible or deformable. For example, the display panel 110 may include sub pixels 830. For example, the display panel 110 may include wirings 840 for the sub pixels 830. For example, while the rigid portion of the display panel 110 includes the sub pixels 830, the other flexible portion of the display panel 110 may include the wirings 840 for the sub pixels 830. For example, each of the sub pixels 830 may include a light emitting element (e.g., a light emitting diode) and one or more transistors used for emitting the light emitting element. For example, each of the sub pixels 830 may further include display driver circuitry 132 for each of the sub pixels 830. For example, a portion of the sub pixels 830 may include the conductive materials 140 of the first set 811, and another portion of the sub pixels 830 may include the conductive materials 140 of the second set 812.

The above exemplified electronic devices may be implemented as an electronic device 901 in the following description. The electronic device 901 may include a display panel 110 (e.g., a portion of a display module 960 of FIG. 9 or a display 1010 of FIG. 10).

FIG. 9 is a block diagram illustrating an electronic device 901 in a network environment 900 according to various embodiments. Referring to FIG. 9, the electronic device 901 in the network environment 900 may communicate with an electronic device 902 via a first network 998 (e.g., a short-range wireless communication network), or at least one of an electronic device 904 or a server 908 via a second network 999 (e.g., a long-range wireless communication network). According to an embodiment, the electronic device 901 may communicate with the electronic device 904 via the server 908. According to an embodiment, the electronic device 901 may include a processor 920, memory 930, an input module 950, a sound output module 955, a display module 960, an audio module 970, a sensor module 976, an interface 977, a connecting terminal 978, a haptic module 979, a camera module 980, a power management module 988, a battery 989, a communication module 990, a subscriber identification module(SIM) 996, or an antenna module 997. In some embodiments, at least one of the components (e.g., the connecting terminal 978) may be omitted from the electronic device 901, or one or more other components may be added in the electronic device 901. In some embodiments, some of the components (e.g., the sensor module 976, the camera module 980, or the antenna module 997) may be implemented as a single component (e.g., the display module 960).

The processor 920 may execute, for example, software (e.g., a program 940) to control at least one other component (e.g., a hardware or software component) of the electronic device 901 coupled with the processor 920, and may perform various data processing or computation. According to an embodiment, as at least part of the data processing or computation, the processor 920 may store a command or data received from another component (e.g., the sensor module 976 or the communication module 990) in volatile memory 932, process the command or the data stored in the volatile memory 932, and store resulting data in non-volatile memory 934. According to an embodiment, the processor 920 may include a main processor 921 (e.g., a central processing unit (CPU) or an application processor (AP)), or an auxiliary processor 923 (e.g., a graphics processing unit (GPU), a neural processing unit (NPU), an image signal processor (ISP), a sensor hub processor, or a communication processor (CP)) that is operable independently from, or in conjunction with, the main processor 921. For example, when the electronic device 901 includes the main processor 921 and the auxiliary processor 923, the auxiliary processor 923 may be adapted to consume less power than the main processor 921, or to be specific to a specified function. The auxiliary processor 923 may be implemented as separate from, or as part of the main processor 921.

The auxiliary processor 923 may control at least some of functions or states related to at least one component (e.g., the display module 960, the sensor module 976, or the communication module 990) among the components of the electronic device 901, instead of the main processor 921 while the main processor 921 is in an inactive (e.g., sleep) state, or together with the main processor 921 while the main processor 921 is in an active state (e.g., executing an application). According to an embodiment, the auxiliary processor 923 (e.g., an image signal processor or a communication processor) may be implemented as part of another component (e.g., the camera module 980 or the communication module 990) functionally related to the auxiliary processor 923. According to an embodiment, the auxiliary processor 923 (e.g., the neural processing unit) may include a hardware structure specified for artificial intelligence model processing. An artificial intelligence model may be generated by machine learning. Such learning may be performed, e.g., by the electronic device 901 where the artificial intelligence is performed or via a separate server (e.g., the server 908). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 930 may store various data used by at least one component (e.g., the processor 920 or the sensor module 976) of the electronic device 901. The various data may include, for example, software (e.g., the program 940) and input data or output data for a command related thereto. The memory 930 may include the volatile memory 932 or the non-volatile memory 934.

The program 940 may be stored in the memory 930 as software, and may include, for example, an operating system (OS) 942, middleware 944, or an application 946.

The input module 950 may receive a command or data to be used by another component (e.g., the processor 920) of the electronic device 901, from the outside (e.g., a user) of the electronic device 901. The input module 950 may include, for example, a microphone, a mouse, a keyboard, a key (e.g., a button), or a digital pen (e.g., a stylus pen).

The sound output module 955 may output sound signals to the outside of the electronic device 901. The sound output module 955 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 960 may visually provide information to the outside (e.g., a user) of the electronic device 901. The display module 960 may include, for example, a display, a hologram device, or a projector and control circuitry to control a corresponding one of the display, hologram device, and projector. According to an embodiment, the display module 960 may include a touch sensor adapted to detect a touch, or a pressure sensor adapted to measure the intensity of force incurred by the touch.

The audio module 970 may convert a sound into an electrical signal and vice versa. According to an embodiment, the audio module 970 may obtain the sound via the input module 950, or output the sound via the sound output module 955 or a headphone of an external electronic device (e.g., an electronic device 902) directly (e.g., wiredly) or wirelessly coupled with the electronic device 901.

The sensor module 976 may detect an operational state (e.g., power or temperature) of the electronic device 901 or an environmental state (e.g., a state of a user) external to the electronic device 901, and then generate an electrical signal or data value corresponding to the detected state. According to an embodiment, the sensor module 976 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 977 may support one or more specified protocols to be used for the electronic device 901 to be coupled with the external electronic device (e.g., the electronic device 902) directly (e.g., wiredly) or wirelessly. According to an embodiment, the interface 977 may include, for example, a high definition multimedia interface (HDMI), a universal serial bus (USB) interface, a secure digital (SD) card interface, or an audio interface.

A connecting terminal 978 may include a connector via which the electronic device 901 may be physically connected with the external electronic device (e.g., the electronic device 902). According to an embodiment, the connecting terminal 978 may include, for example, an HDMI connector, a USB connector, an SD card connector, or an audio connector (e.g., a headphone connector).

The haptic module 979 may convert an electrical signal into a mechanical stimulus (e.g., a vibration or a movement) or electrical stimulus which may be recognized by a user via his tactile sensation or kinesthetic sensation. According to an embodiment, the haptic module 979 may include, for example, a motor, a piezoelectric element, or an electric stimulator.

The camera module 980 may capture a still image or moving images. According to an embodiment, the camera module 980 may include one or more lenses, image sensors, image signal processors, or flashes.

The power management module 988 may manage power supplied to the electronic device 901. According to an embodiment, the power management module 988 may be implemented as at least part of, for example, a power management integrated circuit (PMIC).

The battery 989 may supply power to at least one component of the electronic device 901. According to an embodiment, the battery 989 may include, for example, a primary cell which is not rechargeable, a secondary cell which is rechargeable, or a fuel cell.

The communication module 990 may support establishing a direct (e.g., wired) communication channel or a wireless communication channel between the electronic device 901 and the external electronic device (e.g., the electronic device 902, the electronic device 904, or the server 908) and performing communication via the established communication channel. The communication module 990 may include one or more communication processors that are operable independently from the processor 920 (e.g., the application processor (AP)) and supports a direct (e.g., wired) communication or a wireless communication. According to an embodiment, the communication module 990 may include a wireless communication module 992 (e.g., a cellular communication module, a short-range wireless communication module, or a global navigation satellite system (GNSS) communication module) or a wired communication module 994 (e.g., a local area network (LAN) communication module or a power line communication (PLC) module). A corresponding one of these communication modules may communicate with the external electronic device via the first network 998 (e.g., a short-range communication network, such as Bluetooth^{™}, wireless-fidelity (Wi-Fi) direct, or infrared data association (IrDA)) or the second network 999 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 992 may identify and authenticate the electronic device 901 in a communication network, such as the first network 998 or the second network 999, using subscriber information (e.g., international mobile subscriber identity (IMSI)) stored in the subscriber identification module 996.

The wireless communication module 992 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 992 may support a high-frequency band (e.g., the mmWave band) to achieve, e.g., a high data transmission rate. The wireless communication module 992 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 992 may support various requirements specified in the electronic device 901, an external electronic device (e.g., the electronic device 904), or a network system (e.g., the second network 999). According to an embodiment, the wireless communication module 992 may support a peak data rate (e.g., 20Gbps or more) for implementing eMBB, loss coverage (e.g., 964dB or less) for implementing mMTC, or U-plane latency (e.g., 0.5ms or less for each of downlink (DL) and uplink (UL), or a round trip of 9ms or less) for implementing URLLC.

The antenna module 997 may transmit or receive a signal or power to or from the outside (e.g., the external electronic device) of the electronic device 901. According to an embodiment, the antenna module 997 may include an antenna including a radiating element composed of a conductive material or a conductive pattern formed in or on a substrate (e.g., a printed circuit board (PCB)). According to an embodiment, the antenna module 997 may include a plurality of antennas (e.g., array antennas). In such a case, at least one antenna appropriate for a communication scheme used in the communication network, such as the first network 998 or the second network 999, may be selected, for example, by the communication module 990 (e.g., the wireless communication module 992) from the plurality of antennas. The signal or the power may then be transmitted or received between the communication module 990 and the external electronic device via the selected at least one antenna. According to an embodiment, another component (e.g., a radio frequency integrated circuit (RFIC)) other than the radiating element may be additionally formed as part of the antenna module 997.

According to various embodiments, the antenna module 997 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 901 and the external electronic device 904 via the server 908 coupled with the second network 999. Each of the electronic devices 902 or 904 may be a device of a same type as, or a different type, from the electronic device 901. According to an embodiment, all or some of operations to be executed at the electronic device 901 may be executed at one or more of the external electronic devices 902, 904, or 908. For example, if the electronic device 901 should perform a function or a service automatically, or in response to a request from a user or another device, the electronic device 901, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 901. The electronic device 901 may provide the outcome, with or without further processing of the outcome, as at least part of a reply to the request. To that end, a cloud computing, distributed computing, mobile edge computing (MEC), or client-server computing technology may be used, for example. The electronic device 901 may provide ultra low-latency services using, e.g., distributed computing or mobile edge computing. In another embodiment, the external electronic device 904 may include an internet-of-things (IoT) device. The server 908 may be an intelligent server using machine learning and/or a neural network. According to an embodiment, the external electronic device 904 or the server 908 may be included in the second network 999. The electronic device 901 may be applied to intelligent services (e.g., smart home, smart city, smart car, or healthcare) based on 5G communication technology or IoT-related technology.

FIG. 10 is a block diagram 1000 illustrating the display module 960 according to various embodiments. Referring to FIG. 10, the display module 960 may include a display 1010 and a display driver integrated circuit (DDI) 1030 to control the display 1010. The DDI 1030 may include an interface module 1031, memory 1033 (e.g., buffer memory), an image processing module 1035, or a mapping module 1037. The DDI 1030 may receive image information that contains image data or an image control signal corresponding to a command to control the image data from another component of the electronic device 901 via the interface module 1031. For example, according to an embodiment, the image information may be received from the processor 920 (e.g., the main processor 921 (e.g., an application processor)) or the auxiliary processor 923 (e.g., a graphics processing unit) operated independently from the function of the main processor 921. The DDI 1030 may communicate, for example, with touch circuitry 1050 or the sensor module 976 via the interface module 1031. The DDI 1030 may also store at least part of the received image information in the memory 1033, for example, on a frame by frame basis. The image processing module 1035 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 1010. The mapping module 1037 may generate a voltage value or a current value corresponding to the image data pre-processed or post-processed by the image processing module 1035. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 1010 may be driven, for example, based at least in part on the voltage value or the current value such that visual information (e.g., a text, an image, or an icon) corresponding to the image data may be displayed via the display 1010.

According to an embodiment, the display module 960 may further include the touch circuitry 1050. The touch circuitry 1050 may include a touch sensor 1051 and a touch sensor IC 1053 to control the touch sensor 1051. The touch sensor IC 1053 may control the touch sensor 1051 to sense a touch input or a hovering input with respect to a certain position on the display 1010. To achieve this, for example, the touch sensor 1051 may detect (e.g., measure) a change in a signal (e.g., a voltage, a quantity of light, a resistance, or a quantity of one or more electric charges) corresponding to the certain position on the display 1010. The touch circuitry 1050 may provide input information (e.g., a position, an area, a pressure, or a time) indicative of the touch input or the hovering input detected via the touch sensor 1051 to the processor 920. According to an embodiment, at least part (e.g., the touch sensor IC 1053) of the touch circuitry 1050 may be formed as part of the display 1010 or the DDI 1030, or as part of another component (e.g., the auxiliary processor 923) disposed outside the display module 960.

According to an embodiment, the display module 960 may further include at least one sensor (e.g., a fingerprint sensor, an iris sensor, a pressure sensor, or an illuminance sensor) of the sensor module 976 or a control circuit for the at least one sensor. In such a case, the at least one sensor or the control circuit for the at least one sensor may be embedded in one portion of a component (e.g., the display 1010, the DDI 1030, or the touch circuitry 1050)) of the display module 960. For example, when the sensor module 976 embedded in the display module 960 includes a biometric sensor (e.g., a fingerprint sensor), the biometric sensor may obtain biometric information (e.g., a fingerprint image) corresponding to a touch input received via a portion of the display 1010. As another example, when the sensor module 976 embedded in the display module 960 includes a pressure sensor, the pressure sensor may obtain pressure information corresponding to a touch input received via a partial or whole area of the display 1010. According to an embodiment, the touch sensor 1051 or the sensor module 976 may be disposed between pixels in a pixel layer of the display 1010, or over or under the pixel layer.

As described above, an electronic device may comprise a display panel, which includes sub pixels respectively including light emitting diodes, a pixel definition layer (PDL) defining a layout of the sub pixels, and conductive materials formed in a portion of the PDL, configured to be deformed at least partially based on a user input. The electronic device may comprise display driver circuitry configured to control the light emitting diodes to display an image on the display panel. The electronic device may comprise a processor. The display driver circuitry may be configured to transmit, to the processor, data regarding a state of at least a portion of the conductive materials that is configured to be electrically connected to the display driver circuitry. The processor may be configured to execute a function corresponding to at least partial deformation of the display panel by the user input, based on the data received from the display driver circuitry.

According to an embodiment, at least another portion of the conductive materials may be electrically disconnected from the display driver circuitry.

According to an embodiment, the data may indicate a resistance value of the at least a portion of the conductive materials.

According to an embodiment, the display driver circuitry may be configured to obtain the data based on applying a voltage to the at least a portion of the conductive materials and transmit, to the processor, the data.

According to an embodiment, the display panel may include a switch layer including thin film transistors (TFTs) configured to electrically connect the display driver circuitry to a first electrode layer, the PDL disposed on the switch layer, the first electrode layer disposed between the PDL on the switch layer, a light emitting layer disposed between the PDL on the first electrode layer, and a second electrode layer disposed over the PDL and the light emitting layer. According to an embodiment, the light emitting diodes may be formed by the first electrode layer, the light emitting layer, and the second electrode layer. According to an embodiment, at least a portion of the conductive materials may be configured to be electrically connected to the display driver circuitry via a wiring that is formed in the switch layer.

According to an embodiment, the display panel may include a first planar part, a second planar part facing the first planar part in a folded state of the electronic device, and a folding part located between the first planar part and the second planar part to be bent between an unfolded state of the electronic device and the folded state. According to an embodiment, the at least a portion of the conductive materials may be disposed in the folding part.

According to an embodiment, the at least a portion of the conductive materials may be disposed across an axis for rotation of the second planar part with respect to the first planar part.

According to an embodiment, the display panel may include a part rollable into a housing of the electronic device for change of size of an area that is visible from a front surface of the housing. According to an embodiment, at least a portion of the conductive materials may be disposed in the part. According to an embodiment, at least a portion of the conductive materials may be disposed along a direction in which the part is moved into the housing. According to an embodiment, the processor may be configured to obtain a screen corresponding to the size based on the data and execute the function transmitting information regarding the screen to the display driver circuitry for display of the screen.

According to an embodiment, the conductive materials may be patterned in the portion of the PDL.

According to an embodiment, the conductive materials may include indium tin oxide (ITO) or conductive ink.

According to an embodiment, the at least a portion of the conductive materials may be at least partially deformed according to the at least partial deformation of the display panel.

According to an embodiment, the at least a portion of the conductive materials may be lengthen or shorten in accordance with the at least partial deformation of the display panel.

According to an embodiment, a resistance value of the at least a portion of the conductive materials when the at least a portion of the conductive materials has a first length may be different from a resistance value of the at least a portion of the conductive materials when the at least a portion of the conductive materials has a second length different from the first length.

As described above, an electronic device may comprise a display panel including a first part including sub pixels and a first pixel definition layer (PDL) defining a layout of the sub pixels, and a second part including a second PDL defining dummy sub pixels and a layout of the dummy sub pixels and conductive materials formed in a portion of the second PDL. The display panel may be configured to be at least partially deformed based on a user input. The electronic device may comprise display driver circuitry. The electronic device may comprise a processor. The display driver circuitry may be configured to transmit, to the processor, data regarding a state of the conductive materials configured to be electrically connected to the display driver circuitry. The processor may be configured to execute a function corresponding to at least partial deformation of the display panel by the user input, based on the data received from the display driver circuitry.

According to an embodiment, the display driver circuitry may be configured to obtain the data based on applying a voltage to the conductive materials in the portion of the second PDL in the second part of the display panel, and transmit the data to the processor.

According to an embodiment, the second part of the display panel may include a switch layer, the second PDL disposed on the switch layer, a first electrode layer disposed between the second PDL on the switch layer, a light emitting layer disposed between the second PDL on the first electrode layer, and a second electrode layer disposed over the second PDL and the light emitting layer. According to an embodiment, the first electrode layer may be electrically disconnected from the display driver circuitry. According to an embodiment, the conductive materials formed in the portion of the second PDL may be configured to be electrically connected to the display driver circuitry via at least one wiring formed in the switch layer.

According to an embodiment, the display panel may include a first planar part, a second planar part facing the first planar part in a folded state of the electronic device, and a folding part located between the first planar part and the second planar part to be bent between an unfolded state of the electronic device and the folded state. According to an embodiment, the conductive materials may be disposed in the folding part of the display panel.

According to an embodiment, the conductive materials may be disposed across an axis for rotation of the second planar part with respect to the first planar part.

According to an embodiment, the second part of the display panel may extend from the first part of the display panel. According to an embodiment, the first part of the display panel and the second part of the display panel may be at least partially rollable into a housing the electronic device for change of size of an area that is visible from a front surface of the housing. According to an embodiment, the conductive materials may be disposed along a direction in which the second part is moved into the housing within the second part that is at least partially rollable into the housing.

According to an embodiment, the processor may be configured to obtain a screen corresponding to the size based on the data, and execute the function by transmitting, to the display driver circuitry, information regarding the screen for display of the screen.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 940) including one or more instructions that are stored in a storage medium (e.g., internal memory 936 or external memory 938) that is readable by a machine (e.g., the electronic device 901). For example, a processor (e.g., the processor 920) of the machine (e.g., the electronic device 901) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a display panel, which includes sub pixels respectively including light emitting diodes, a pixel definition layer (PDL) defining a layout of the sub pixels, and conductive materials formed in a portion of the PDL, configured to be at least partially deformed based on a user input;
display driver circuitry configured to control the light emitting diodes to display an image on the display panel; and
a processor,
wherein the display driver circuitry is configured to transmit to the processor data regarding a state of at least a portion of the conductive materials that is configured to be electrically connected to the display driver circuitry, and
wherein the processor is configured to execute a function corresponding to at least partial deformation of the display panel by the user input, based on the data received from the display driver circuitry.

2. The electronic device of claim 1, wherein at least another portion of the conductive materials is electrically disconnected from the display driver circuitry.

3. The electronic device of claim 1, wherein the data indicates a resistance value of the at least a portion of the conductive materials.

4. The electronic device of claim 1, wherein the display driver circuitry is configured to:
obtain the data based on applying voltage to the at least a portion of the conductive materials; and
transmit, to the processor, the data.

5. The electronic device of claim 1, wherein the display panel includes:
a switch layer including thin film transistors (TFTs) configured to electrically connect the display driver circuitry to a first electrode layer;
the **PDL** disposed on the switch layer;
the first electrode layer disposed between the **PDL** on the switch layer;
a light emitting layer disposed between the **PDL** on the first electrode layer; and
a second electrode layer disposed over the **PDL** and the light emitting layer,
wherein the light emitting diodes are formed by the first electrode layer, the light emitting layer, and the second electrode layer, and
wherein the at least a portion of the conductive materials is configured to be electrically connected to the display driver circuitry via a wiring that is formed in the switch layer.

6. The electronic device of claim 1, wherein the display panel includes a first planar part, a second planar part facing the first planar part in a folded state of the electronic device, and a folding part located between the first planar part and the second planar part to be bent between an unfolded state of the electronic device and the folded state, and
wherein the at least a portion of the conductive materials is disposed in the folding part.

7. The electronic device of claim 6, wherein the at least a portion of the conductive materials is disposed across an axis for rotation of the second planar part with respect to the first planar part.

8. The electronic device of claim 1, wherein the display panel includes a part rollable into a housing of the electronic device for change of size of area that is visible from a front surface of the housing, and
wherein the at least a portion of the conductive materials is disposed in the part.

9. The electronic device of claim 8, wherein the at least a portion of the conductive materials is disposed along a direction in which the part is moved into the housing.

10. The electronic device of claim 8, wherein the processor is configured to:
obtain a screen corresponding to the size, based on the data; and
execute the function by transmitting information regarding the screen to the display driver circuitry for display of the screen.

11. The electronic device of claim 1, wherein the conductive materials are patterned in the portion of the **PDL.**

12. The electronic device of claim 1, wherein the at least a portion of the conductive materials is at least partially deformed according to the at least partial deformation of the display panel.

13. The electronic device of claim 1, wherein the at least a portion of the conductive materials is at least partially deformed according to the at least partial deformation of the display panel.

14. The electronic device of claim 13, wherein the at least a portion of the conductive materials is lengthen or shorten in accordance with the at least partial deformation of the display panel.

15. The electronic device of claim 14, wherein a resistance value of the at least a portion of the conductive materials when the at least a portion of the conductive materials has a first length is different from a resistance value of the at least a portion of the conductive materials when the at least a portion of the conductive materials has a second length different from the first length.
